# EUROPEAN PATENT SPECIFICATION

(11) **EP 0 443 277 B1**
(45) Date of publication and mention of the grant of the patent: **30.12.1998**
(21) Application number: 90400458.7
(22) Date of filing: 20.02.1990
(51) Int. Cl.: C04B 41/85, C23C 16/42, C04B 41/51

(54) **Metallized ceramic body and method to make the same**
Metallisierte keramische Körper und Verfahren zu deren Herstellung
Corps céramique métallisé et méthode pour le produire

(43) Date of publication of application: 28.08.1991
(73) Proprietor: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventor: Jalby, Pierre, Tsuchiura (JP); Rotman, Frederic, F-75005 Paris (FR); Claverie, Pierre, Tsuchiura (JP); Arai, Juichi, Ibaraki Pref. T310 (JP); Kimura, Maso, Tsuchiura (JP); Friedt, Jean-Marie, Room 104 - Manoir Fusukawa 19, Shinjuku-ku T162, Tokyo (JP)
(74) Representative: Vesin, Jacques

(56) References cited:
- EP-A- 0 157 052
- EP-A- 0 245 934
- EP-A- 0 247 783
- EP-A- 0 305 143
- FR-A- 2 344 642
- JOURNAL OF THE ELECTROCHEMICAL SOCIETY. vol. 135, no. 7, July 1988, MANCHESTER, NEW HAMP pages 1752 - 1757; G. A. West et al: "Chemical vapor deposiotion of Molybdenum Silicide"

## Description

### BACKGROUND OF THE INVENTION

### Field of the invention

The present invention relates to a sintered ceramic body formed with a metallized layer on its surface, said metallized layer essentially comprising a metal or a metal alloy selected among tungsten or molybdenum. It also relates to a method of forming the same on a sintered ceramic body.

### Description of the prior Art

As microelectronic technology advances and chips become more and more integrated, the other materials used to fabricate circuits must keep pace with the improved technologies. A main concern in hybrid technology is the heat disisipation due to both integration and power increase of semi-conductor chips. Among the various ways used to remove the heat, thermal conduction through the substrate to which the chip is connected, generally a metallized ceramic plate, is the most important.

In order to enhance this heat dissipation, one possibility consists in using high thermal conductivity ceramic materials. Although alumina (Al₂O₃) thermal conductivity is rather low (about 30 W/m.K.), it is the most often used ceramic substrate. Thus, Beryllia (Beo) is sometimes used for high power applications since its thermal conductivity is about 250 W/m.K. More recently, aluminium nitride (AIN) appears to be one of the most promising candidate materials showing high thermal conductivity (ranging from about 140 to 200 W/m. K. for today's commercial products) without the toxicity of BeO powder. Aluminium nitride has also more balanced characteristics (thermal expansion coefficient similar to that of silicon, low dielectric constant, high bonding strength,..) than other ceramic substrates, and thus the field of uses is expected to be wider as described by Brunner et al. in an article entitled "Metallized Aluminium Nitride Ceramics : potential, properties, application" published in INTERCERAM N^{o} 4 pp 29 - 32 1988. Other ceramic materials such as boron nitride and silicon carbide-based materials have been also investigated and are possible candidates.

Anyway, the use of ceramic materials as microelectronic substrates requires a reliable metallization in terms of electrical and mechanical properties. Thus, in order to have a high thermal conduction, not only the ceramic substrate but also the metallized layer between the chip and the ceramic must show good heat properties.

Refractory metals such as tungsten, molybdenum are particularly good candidates thanks to their high thermal conductivity and expansion coefficients close to silicon. Moreover, it is possible to use high temperature processes such as brazing or the like, which are necessary for high power applications.

The commonly used metallization process of refractory metals consists in depositing on the substrate a paste made of refractory metal powders and additives (typically organic vehicles to allow deposition and frit glasses or inorganic additives to enhance adhesion) followed by a sintering at high temperature, generally above 1400 C. During this heat treatment, creation of intermediate layers at the refractory metal-ceramic interface, allows good adhesion. This method (sometimes called Moly-manganese process) has been developed for alumina (Al₂0₃) and can be applied to other oxide ceramic substrate like BeO (see for more details "Effect of sintering conditions on Al₂O₃-MoMn bond strengths" - Ceramic Bulletin, vol.50 N^{o} 12 (1971) M.E. ARTHUR et al).

This method is not suitable for non-oxide ceramics, and particularly to AlN.

To complete refractory metal deposition on AlN, it has been recently proposed to modify paste compositions. In particular, other types of additives than those used for oxide ceramic substrates have been suggested. It is known from EP-A-276788 a method of metallizing the surface of an Aluminium Nitride with Mo or W pastes containing additive compounds such CaO, CaCO₃, or the like, to improve the bonding strength. The pastes consisting of W or Mo metal powders are screen-printed, and sintered at high temperature between 1550-1800°C.

In a similar manner, M. ASAI et al in "Titanium nitride-molybdenum metallizing method for Aluminium nitride" IEEE Japan - IEMT proceedings - 1989 - pp 221-224. disclose a method of metallizing Aluminium Nitride substrates. A paste containing Molybdenum Mo and Titanium Nitride TiN powders is printed on AlN substrates and postfired at 1700-1800 C.

This paste sintering method has however several drawbacks :
- Very high temperature processing ranging from about 1400 to 1800^{°}C for the sintering of refractory metals.
- a rather long time processing (about 1h or 2h).
- a non-optimum thermal conductivity due to the formation of intermediate layers at the metal-ceramic interface.
- a rather expensive process due to energy costs for high temperature and time processing.

It is known to enhance the heat dissipation by addition of a metallic heat spreader between the chip and the ceramic substrate. For the above-mentioned reasons, tungsten or molybdenum make good heat spreaders. However, such refractory metallic heat spreaders usually need additionnal metallization of their both sides in order to be soldered, on one hand to the silicon chip, on the other hand to a metallized part of the ceramic substrate. Thus, the manufacturing of such a complex hybrid assembly requires numerous operations implying high costs. Furthermore, a complex system containing several solder joints has several drawbacks from the point of view of heat dissipation (increase of thermal resistance).

It is also known from the Journal of the Electrochemical Society 135 (1988), No. 7, pages 1752-1757, an alumina body coated with molybdenum silicide having a molar ratio Si/Mo which can be in certain circumstances smaller than 2 but which is usually greater than 2.

### SUMMARY OF THE INVENTION

The present invention proposes a metallization method of refractory metals, essentially molybdenum and tungsten, on both oxide and non-oxide ceramics, preferably alumina-based materials for oxide ceramics and preferably aluminum nitride-based materials for non-oxide ceramics, by a CVD process using silicon hydride gases (SiₙH₂ₙ₊₂) and metal halides gases. As a matter of fact, it has been found that by using such a CVD process, a direct metallization with sufficient adhesion for micro-electonics applications can be obtained, while avoiding disadvantages such as limitation of heat dissipation, attributed to intermediate layers generated in common pastes processes at the metal-ceramic interface. Contrary to known processes wherein a step of pre-metallization or brazing a metal or alloy layer are provided, the method according to the invention uses direct deposition of the refractory metallic layer on the ceramic sintered body.

The sintered ceramic body according to the invention is characterized in that the metallized layer is deposited by a CVD method on said body, in that it is formed by reaction of gases comprising tungsten and/or molybdenum halides on the one hand and silicon hydrides on the other hand, in that said metallized layer is directly deposited on to the ceramic sintered body and in that the metallised layer is made of a refractory metal layer M Si_{z}, M being tungsten and/or molybdenum, Z being the molar ratio of silicium Si to metal M, with 0.01<Z<0.1.

The process according to the invention is characterized in that it further comprises the steps of introducing the sintered ceramic body in a CVD enclosure evacuating the enclosure at the adequate pressure injecting a first gas or gas mixture selected from tungsten and/or molybdenum halide gases, injecting substantially at the same time a second gas or gas mixture comprising at least one silicon hydride gas, producing the reaction between said halide and said hydride gases, depositing a tungsten and/or molybdenum layer on said sintered ceramic body, removing the metallized sintered ceramic body from the CVD enclosure, and providing a metallized layer M Si_{z} wherein 0.01<Z<0.1.

Moreover, an important and innovative advantage of the present method is the possibility to vary the metallization thickness at will, from about 5 x 10⁻⁷m to a few 10⁻⁴m (0.5 microns) to a few hundreds microns. In some cases, it can be a simple and immediate metallization of ceramics from 5 x 10⁻⁷m to a few 10⁻⁶m (from 0.5 to a few microns thickness), in other cases, the growth of the refractory metal deposit several 10⁻⁵m up to a few 10⁻⁴m (several tens microns up to a few hundreds microns) leads to the direct formation of a metallic heat spreader/ceramic system. Thus, the adequate thickness for each application can be chosen in order to effectively dissipate the heat for each given electronic assembly package.

In accordance with the method of the present invention, silicon hydride gas and metal halide gas are mixed in adequate proportions and injected in a CVD reactor containing the ceramic substrate heated at a controlled temperature.

The metal halide gas may be a fluoride gas or chloride gas such as WF₆, WCl₆, MoF₆ and MoCl₆.

The silicon hydride gas is a gas indicated with a chemical formula SiₙH₂ₙ₊₂ (n = 1, 2, 3...), preferably SiH₄.

A temperature between about 20°C to about 750°C is set for deposition.

The ratio of flowrates of silicon hydride/metal halide is set between 0.2 and 5.

The pressure inside the reactor can be set between 1,33 Pa (0.01 Torr) and atmospheric pressure.

The silicon hydride gas (SiₙH₂ₙ₊₂) reduces the metal halide gas (MX₆), and the deposited refractory metal layer can be described by the chemical formula MSi_{Z} (M indicates metal, the molar ratio "Z" of Si to M varies: 0.01 < Z < 0.1).

As a function of experimental conditions, one can manage to gee essentially pure tungsten, with a silicon amount of a few atomic per cents (between about 1 and 7 %). In the case of SiH₄, the preferable conditions for the formation of such essentially pure tungsten layers are as follows :
- the ratio of the flow rate SiH₄/WF₆ is between about 0.5 to about 0.8
- the deposition temperature is set from about 300°C to 600°C.

On the other hand, it is also within the scope of the present invention to deposit a metallic layer with at least several atomic per cents of Silicon (greater than about 7 %). In the case of SiH₄ and WF₆ gases, the preferred conditions for the formation of the metal alloy layer WSi_{Z} are as follows :
- the ratio of flowrates SiH₄/WF₆ is greater than 0.8.
- the temperature range is between 300°C to 600°C.

In the case of SiH₄ and MoF₆ gases, the preferable conditions for the formation of such layers MoSi_{Z} are as follows :
- the ratio of the flow rate SiH₄/MoF₆ is between 2 and 5.
- the temperature deposition range is between 300°and 600°C

One of the main advantages already discussed is the possibility to adjust the thickness (from 0.5 x 10⁻⁶m to a few 10⁻⁴m) for each application in order to effectively dissipate the heat for a given electronic assembly package.

In the case of thin metallizations (about a few 10⁻⁶m), the main advantages compared with the screen-printed pastes process are the following :
- the process temperature is much lower : 200°to 300°C is even sufficient whereas the screen-printed pastes process induces very high temperature, typically above 1400°C.
- the addition of inorganic compounds is not necessary, avoiding thus a decrease of the heat dissipation.

On the other hand, in the case of thick deposition (several 10⁻⁵m up to a few 10⁻⁴m), compared with the usual complex hybrid process to make refractory metal heat spreaders, the main advantages are the following :
- a single step process, compared to a multiple and complex steps process (with numerous metallizations and solders).
- all intermediate layers and solder joints are removed, avoiding thus heat dissipation limitations.
- an adjustable thickness. As a function of the desired thermal properties for a given hybrid assembly, the adequate thickness can be chosen to dissipate the corresponding heat.

### BRIEF DESCRIPTION OF THE DRAWINGS

Fig 1 is a sectional view showing an example of application of the present invention which can be applied to a heat sink for a semiconductor device. Such a device can be, e.g., a Field Effect Transistor (FET) or a Thyristor or Light Emitting Diode (LED) or a Laser Diode (LD) or any integrated circuits.
Fig 2 is a graph showing a CVD system as used in the examples.
Fig 3 is a graph showing X-Ray diffraction pattern for W layer when Si amount is very low and nearly pure metal is obtained.
Fig 4 illustrates a test for measuring adhesive strength of a metallized layer formed on the surface of a ceramic substrate according to the present invention.

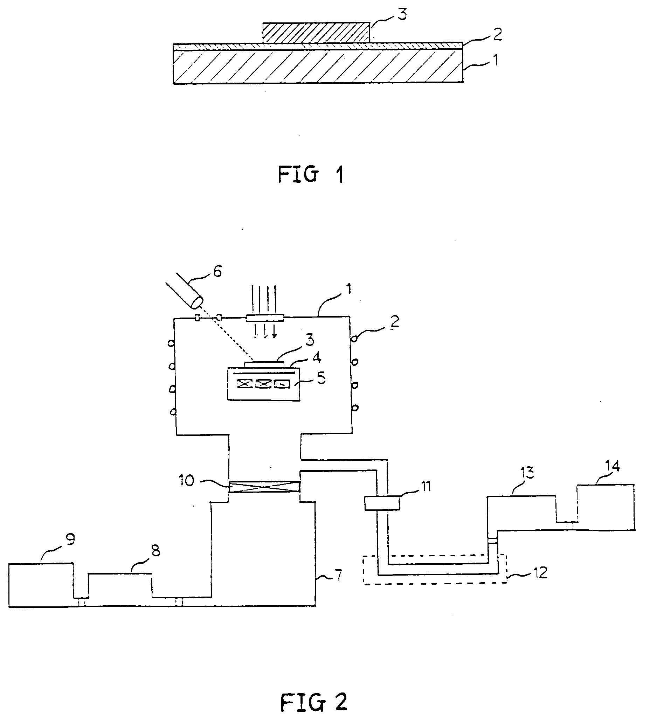

Fig 1 is a sectional view showing an example of application of a metallized ceramic substrate manufactured through the above described method of the present invention to be applied to a package for a semiconductor device. The ceramic substrate 1 comprises a metallized layer 2 on its surface. A semiconductor element 3 such is joined on the ceramic substrate 1.

Description is now made in connection with Examples 1 to 3.

### EXAMPLE 1

Fig 2 shows a CVD system used to carry out the present example. It comprised the gas distribution system, the cold wall type chamber, the heating system, and the pumping system. The available gases are SiH₄, WF₆ (or MoF₆, WCl₆, MoCl₆), He and Ar. Helium (He) is used as a carrier gas for metal halides. Argon is used to purge the chamber after the deposition is completed.

Chamber (1) is a cold wall type water cooled (2) reactor made of stainless steel. The ceramic substrate, in this example AlN substrate (3) is set on a quartz glass plate (4) under which is a radient heater (5) with three infrared lamps, positioned in the middle of the chamber.

The substrate temperature is measured by an infrared pyrometer (6). The chamber is pumped on by a turbo molecular pump (7) which is backed by one master booster pump (8) and a rotary pump (9). A pressure base around 10⁻⁶ Torr (1.33 x 10⁻⁴ Pa) can be easily reached.

A gate valve (10) isolates the chamber from the turbomolecular pump. In addition a second pumping line bypassing the gate valve and containing a butterfly pressure controlling valve (11), a trap for detoxification (12), a master booster pump (13) and rotary pump (14) is operated during deposition.

An Aluminium Nitride substrate (3) is set in the chamber (1) and when the pressure base is reached, typically around 1,33 x 10⁻⁴ Pa 10⁻⁶ Torr the pumping line is exchanged for that used for deposition.

The substrate is heated at 400°C. After the stabilization of the substrate temperature, SiH₄, WF₆ and He gases are injected with a ratio SiH₄/WF₆ = 0.75, with the following flow rates :
SiH₄ : 7,5 sccm
WF₆ : 10 sccm
He : 64 sccm

Deposition time is 4 minutes. The pressure inside the chamber is set at 26,6 Pa (0.2 Torr.) After the deposition was completed several purges were carried out with Ar gas.

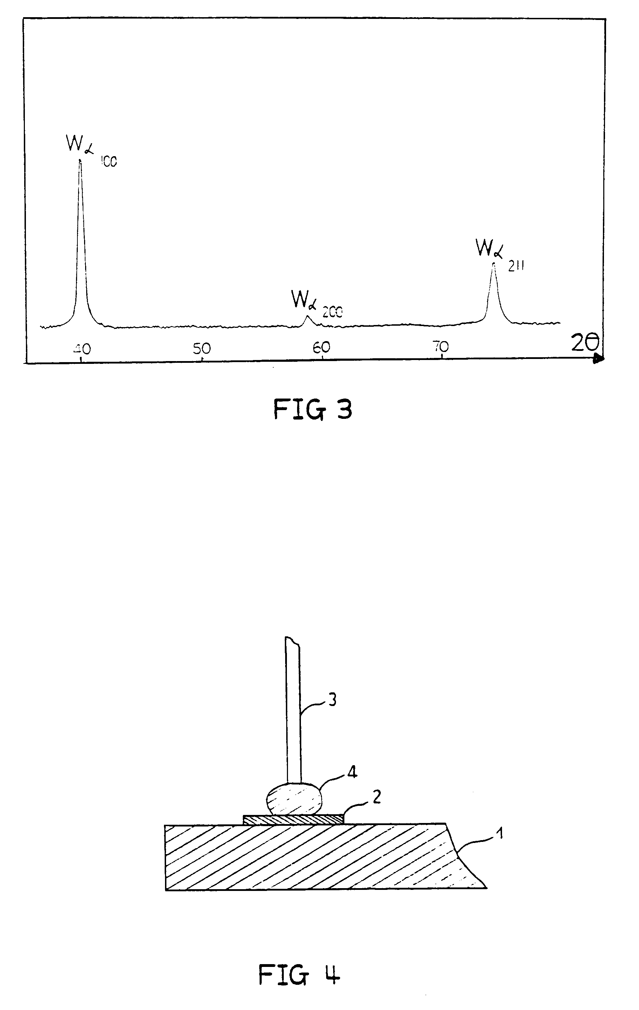

Characterization of deposited metal layer comprises three steps :
- A Scanning Electronic Microscope (SEM) analysis in order to determine the morphology and especially the thickness of the layer by cross section views of the sample. With a thickness of 5 x 10⁻⁶m obtained in 4 minutes, that means a deposition rate of 1.25 10⁻⁶m/min.
- X-Ray diffraction analysis result showed on fig 3 is carried out on the sample obtained under the abovementioned conditions of this example. This graph shows the three characteristic peaks of Tungsten W alpha phase.
- Pulling tests are disclosed on Fig.4 to give the value of the bonding strength between the layer and the ceramic Aluminium Nitride substrate. In this example according to the present invention, the value obtained is 3.2. ± 0.4.kg/mm². The bonding strengths obtained in this example is thus very good for hybrid circuit applications.

Referring to fig 4, Nickel plating is carried out on a prescribed surface part (typically 2 mm by 2 mm) of a metallized layer 2 which is formed on the ceramic substrate 1. Thereafter, a stainless wire 3 of 0,8 mm diameter is soldered on the same by metal brazing 4. The stainless steel wire 3 is pulled up to measure the tensile strength of the metallized layer.

### EXAMPLE 2

Under the same conditions as those disclosed in example 1, an Alumina substrate is set is the reactor, then heated at 500°C.

After the temperature stabilization, the following gas mixture is isolated in the reactor :
6 sccm of SiH₄
10 sccm of WF₆
64 sccm of He

The deposition duration is two hours. The pressure inside the chamber is set at 53,2 Pa (0.4 Torr.) The ratio SiH₄/WF₆ is maintained at substantially 0.60. The thickness of the layer is 94 micrometres, i.e. a deposition rate which is about 0.8 10⁻⁶m/min.

Pulling tests made in the same conditions as those of example 1 give a bonding strength of 1.6. ± 0.2. kg/mm². This adhesion value is highly sufficient for hybrid circuit application.

### EXAMPLE 3: COMPARATIVE EXAMPLE

This third example describes a deposition of Molybdenum layer containing some Silicon MoSi_{z} on a ceramic substrate, e.g., in this case AIN.

Under the same conditions as those disclosed in example 1 an Aluminium Nitride substrate is set in the reactor, then heated at 320°C. After temperature stabilization, the following gas mixture is injected in the reactor :
10 sccm of MoF₆
22 sccm of SiH₄
64 sccm of He

The deposition time is 10 minutes. The pressure inside the chamber is set at 26,6 Pa (0.2 Torr.) The ratio SiH₄/MoF₆ is maintained around 2,2.

A qualitative analysis with a X-Ray analyser coupled with the SEM indicates the presence of Silicon in the deposited layer.

A layer of 38 micrometres thick is obtained in 10 minutes, i.e. a deposition rate of about 3,8 10⁻⁶m/min.

Pulling tests realised in the same conditions as those described in example 1 indicate a bonding strength of 2.1. ± 0,3 kg/mm², which is highly sufficient for hybrid circuit applications.

## Claims

1. A sintered ceramic body formed with a metallized layer on its surface, said metallized layer essentially comprising a metal or metal alloy selected from the group comprising tungsten and/or molybdenum characterized in that the metallized layer is deposited by a CVD method on said body, in that it is formed by reaction of gases comprising tungsten and/or molybdenum halides on the one hand and silicon hydrides on the other hand, in that said metallized layer is directly deposited on to the ceramic sintered body and in that the metallized layer is made of a refractory metal layer M Si_{z}, M being tungsten and/or molybdenum, Z being the molar ratio of silicium Si to metal M, with 0.01<Z<0.1.

2. A sintered ceramic body according to claim 1, characterized in that the ceramic material is a non-oxide ceramic material.

3. A sintered ceramic body according to claim 2, characterized in that the non-oxide ceramic material is aluminum nitride based materials, silicon carbide based materials or boron nitride based materials.

4. A sintered ceramic body according to claim 1, characterized in that ceramic material is an oxide based ceramic material.

5. A sintered ceramic body according to claim 4, characterized in that the oxide ceramic material is selected from the group comprising aluminum oxide or berylium oxide.

6. A sintered ceramic body according to one of claims 1 to 5, characterized in that the thickness of the metallized layer is comprised between 0.5 and 600 micrometers.

7. A sintered ceramic body according to comprised claim 6, characterized in that the thickness of the metallized layer is between 0.5 and 25 micrometers.

8. A sintered ceramic body according to claim 6, characterized in that the thickness of the metallized layer is comprised between 25 to 600 micrometers.

9. A process of manufacturing a metallized sintered ceramic body comprising the steps of providing a sintered ceramic body, depositing a metallized layer essentially comprising a metal or metal alloy selected from the group comprising tungsten and/or molybdenum, characterized in that it further comprises the steps of introducing the sintered ceramic body in a CVD enclosure evacuating the enclosure at the adequate pressure injecting a first gas or gas mixture selected from tungsten and/or molybdenum halide gases, injecting substantially at the same time a second gas or gas mixture comprising at least one silicon hydride gas, producing the reaction between said halide and said hydride gases, depositing a tungsten and/or molybdenum layer on said sintered ceramic body, removing the metallized sintered ceramic body from the CVD enclosure, and providing a metallized layer M Si_{z} wherein 0.01<Z<0.1.

10. A process according to claim 9, characterized in that the halide gases are the fluoride and the chloride gases WF₆, MoF₆, WCL₆, MoCL₆ and their mixtures.

11. A process according to claim 9 or 10, characterized in that the silicon hydride gases are SiH₄, Si₂H₆ and Si₃H₈ or a mixture thereof.

12. A process according to any one of the claims 9 to 11, characterized in that the temperature in the CVD enclosure during the deposition step is comprised between about 20°C and about 750°C.

13. A process according to any one of claims 9 to 12, characterized in that the pressure in the CVD enclosure is between 1,33 Pa (0.01 Torr) and the atmospheric pressure.

14. A process according to any one of claims 9 to 13, characterized in that the ratio of flowrates between the silicon hydride gas and the metal halide gas is comprised between about 0.2 to about 5.

15. A process according to any one of claims 9 to 14, characterized in that the silicon hydride gas is silane, SiH₄ and the metal halide gas in tungsten halide gas.

16. A process according to claim 15, characterized in that the ratio of flowrates of silane gas to tungsten halide gas is comprised between about 0.5 to about 0.8.

17. A process according to claim 15, characterized in that the ratio of flowrates of silane gas to tungsten halide gas is greater than 0.8.

18. A process according to any one of claims 9 to 14, characterized in that the silicon hydride gas is silane SiH₄ and the metal halide gas is molybdenum halide gas.

19. A process according to claim 18, characterized in that the ratio of flowrates of silane gas to molybdenum halide gas is comprised between about 2 to 5.

20. A process according to any one of claims 15 to 19, characterized in that the temperature is comprised between about 300°C and about 600°C.

## Patentansprüche

1. Ein gesinterter Keramikkörper, der mit einer metallisierten Schicht auf seiner Oberfläche gebildet wird, wobei diese metallisierte Schicht im wesentlichen ein Metall oder eine Metallegierung, ausgewählt aus der Gruppe enthaltend Wolfram und/oder Molybdän, dadurch gekennzeichnet, daß die metallisierte Schicht durch ein CVD-Verfahren auf diesem Körper abgeschieden wird, indem sie durch die Reaktion von Gasen enthaltend Wolfram- und/oder Molybdänhalogenide auf der einen Seite und Siliciumhydride auf der anderen Seite gebildet wird, wobei die metallisierte Schicht direkt auf den keramischen gesinterten Körper abgeschieden wird und indem die metallisierte Schicht aus einer schwer schmelzenden Metallschicht M Si_{Z} besteht, wobei M für Wolfram und/oder Molybdän steht, Z für das molare Verhältnis von Silicium Si zu Metall M steht, mit 0,01 < Z < 0,1.

2. Ein gesinterter Keramikkörper nach Anspruch 1, dadurch gekennzeichnet, daß das Keramikmaterial ein nichtoxidisches Keramikmaterial ist.

3. Ein gesinterter Keramikkörper nach Anspruch 2, dadurch gekennzeichnet, daß das nichtoxidische keramische Material aluminiumnitritbasierte Materialien, siliciumcarbidbasierte Materialien oder bomitritbasierte Materialien sind.

4. Ein gesinterter Keramikkörper nach Anspruch 1, dadurch gekennzeichnet, daß das keramische Material ein oxidisches keramisches Material ist.

5. Ein gesinterter Keramikkörper nach Anspruch 4, dadurch gekennzeichnet, daß das oxidische keramische Material ausgewählt ist aus der Gruppe umfassend Aluminiumoxid oder Berylliumoxid.

6. Ein gesinterter Keramikkörper nach einem der Ansprüche 1 bis 5, dadurch gekennzeichnet, daß die Dicke der metallisierten Schicht zwischen 0,5 und 600 Mikrometern liegt.

7. Ein gesinterter Keramikkörper nach Anspruch 6, dadurch gekennzeichnet, daß die Dicke der metallisierten Schicht zwischen 0,5 und 25 Mikrometern liegt.

8. Ein gesinterter keramischer Körper nach Anspruch 6, dadurch gekennzeichnet, daß die Dicke der metallisierten Schicht zwischen 25 und 600 Mikrometern liegt.

9. Ein Verfahren zur Herstellung eines metallisierten, gesinterten Keramikkörpers, umfassend die Schritte des zur Verfügungstellens eines gesinterten Keramikkörpers, der Abscheidung einer metallisierten Schicht, die im wesentlichen ein Metall oder eine Metallegierung, ausgewählt aus der Gruppe enthaltend Wolfram und/oder Molybdän umfaßt, dadurch gekennzeichnet, daß es weiterhin die Schritte des Einführens des gesinterten Keramikkörpers in eine CVD-Kammer, Evakuieren der Kammer bei einem geeigneten Druck, Injizieren eines ersten Gases oder Gasmischung ausgewählt aus Wolfram- und/oder Molybdärhalogenidgasen, Injizieren zum im wesentlichen gleichen Zeitpunkt eines zweiten Gases oder Gasmischung umfassend wenigstens ein Siliciumhydridgas, Hervorrufen der Reaktion zwischen den genannten Halogen- und den genannten Hydridgasen, Abscheiden einer Wolfram- und/oder Molybdänschicht auf dem genannten gesinterten Keramikkörper, Entfernen des metallisierten gesinterten Keramikkörpers aus der CVD-Kammer und Zur-Verfägung-Stellen einer metallisierten Schicht M Si_{Z}, worin 0,01 < Z < 0,1.

10. Verfahren nach Anspruch 9, dadurch gekennzeichnet, daß die Halogenidgase die Fluorid- und die Chloridgase WF₆, MoF₆, WCl₆, MoCl₆ und deren Gemische sind.

11. Verfahren nach Anspruch 9 oder 10, dadurch gekennzeichnet, daß die Silikonhydridgase SiH₄, Si₂H₆ und Si₃H₈ oder ein Gemisch davon sind.

12. Verfahren nach einem der Ansprüche 9 bis 11, dadurch gekennzeichnet, daß die Temperatur in der CVD-Kammer während des Abscheidungsschrittes zwischen etwa 20°C und etwa 750°C liegt.

13. Verfahren nach einem der Ansprüche 9 bis 12, dadurch gekennzeichnet, daß der Druck in der CVD-Kammer zwischen 1,33 Pa (0,01 Torr) und Atmosphärendruck liegt.

14. Verfahren nach einem der Ansprüche 9 bis 13, dadurch gekennzeichnet, daß das Verhältnis der Flußraten von Silikonhydridgas zu Metallhalogenidgas zwischen etwa 0,2 und etwa 5 liegt.

15. Verfahren nach einem der Ansprüche 9 bis 14, dadurch gekennzeichnet, daß das Siliciumhydridgas Silan, SiH₄, und das Metallhalogenidgas Wolframhalogenidgas ist.

16. Verfahren nach Anspruch 15, dadurch gekennzeichnet, daß das Verhältnis der Flußraten von Silangas zu Wolframhalogenidgas zwischen etwa 0,5 und etwa 0,8 liegt.

17. Verfahren nach Anspruch 15, dadurch gekennzeichnet, daß das Verhältnis von Flußraten von Silangas zu Wolframhalogenidgas größer als 0,8 ist.

18. Verfahren nach einem der Ansprüche 9 bis 14, dadurch gekennzeichnet, daß das Siliciumhydridgas Silan, SiH₄, und das Metallhalogenidgas Molybdänhalogenidgas ist.

19. Verfahren nach Anspruch 18, dadurch gekennzeichnet, daß das Verhältnis von Flußraten von Silangas zu Molybdänhalogenidgas zwischen etwa 2 und 5 liegt.

20. Verfahren nach einem der Ansprüche 15 bis 19, dadurch gekennzeichnet, daß die Temperatur zwischen etwa 300°C und etwa 600°C liegt.

## Revendications

1. Corps en céramique fritté formé avec une couche métallisée sur sa surface, ladite couche métallisée comprenant essentiellement un métal ou un alliage métallique choisi dans le groupe constitué par le tungstène et/ou le molybdène, caractérisé en ce que la couche métallisée est déposée sur ledit corps par un procédé CVD, en ce qu'il est formé par la réaction de gaz comprenant des halogénures de tungstène et/ou de molybdène d'une part et des hydrures de silicium d'autre part, en ce que ladite couche métallisée est déposée directement sur le corps fritté en céramique et en ce que la couche métallisée est faite d'une couche de métal réfractaire MSi_{Z}, M étant le tungstène et/ou le molybdène, Z étant le rapport molaire du silicium Si au métal M, avec 0,01<Z<0,1.

2. Corps en céramique fritté selon la revendication 1, caractérisé en ce que le matériau céramique est un matériau céramique non-oxyde.

3. Corps en céramique fritté selon la revendication 2, caractérisé en ce que le matériau céramique non-oxyde est un matériau à base de nitrure d'aluminium, un matériau à base de carbure de silicium ou un matériau à base de nitrure de bore.

4. Corps en céramique fritté selon la revendication 1, caractérisé en ce que le matériau céramique est a matériau céramique à base d'oxyde.

5. Corps en céramique fritté selon la revendication 4, caractérisé en ce que le matériau céramique à base d'oxyde est l'oxyde d'aluminium ou l'oxyde de béryllium.

6. Corps en céramique fritté selon l'une quelconque des revendications 1 à 5, caractérisé en ce que l'épaisseur de la couche métallisée est comprise entre 0,5 et 600 micromètres.

7. Corps en céramique fritté selon la revendication 6, caractérisé en ce que l'épaisseur de la couche métallisée est comprise entre 0,5 et 25 micromètres.

8. Corps en céramique fritté selon la revendication 6, caractérisé en ce que l'épaisseur de la couche métallisée est comprise entre 25 et 600 micromètres.

9. Procédé de fabrication d'un corps en céramique fritté métallisé comprenant les étapes consistant à pourvoir un corps en céramique fritté, déposer une couche métallisée essentiellement composée d'un métal ou d'un alliage métallique choisi dans le groupe constitué par le tungstène et/ou le molybdène, caractérisé en ce qu'il comprend, en outre, les étapes consistant à introduire le corps en céramique fritté dans une enceinte de CVD, à dépressuriser l'enceinte à la pression adéquate, à injecter un premier gaz ou mélange de gaz choisi parmi les gaz d'halogénures de tungstène et/ou de molybdène, à injecter essentiellement en même temps un deuxième gaz ou mélange de gaz comprenant au moins un gaz d'hydrure de silicium, à produire la réaction entre ledit gaz d'halogénure et ledit gaz d'hydrure, à déposer une couche de tungstène et/ou de molybdène sur ledit corps en céramique fritté, à retirer le corps en céramique fritté métallisé de l'enceinte de CVD et à obtenir une couche métallisée MSi_{Z}, dans laquelle 0,01<Z<0,1.

10. Procédé selon la revendication 9, caractérisé en ce que les gaz d'halogénure sont les gaz de fluorure et de chlorure WF₆, MoF₆, WCl₆, MoCl₆, et leurs mélanges.

11. Procédé selon la revendication 9 ou 10, caractérisé en ce que les gaz d'hydrure de silicium sont SiH₄, Si₂H₆ et Si₃H₈, ou un mélange de ceux-ci.

12. Procédé selon l'une quelconque des revendications 9 à 11, caractérisé en ce que la température dans l'enceinte de CVD durant l'étape de dépôt est comprise entre environ 20°C et environ 750°C.

13. Procédé selon l'une quelconque des revendications 9 à 12, caractérisé en ce que la pression dans l'enceinte de CVD est comprise entre 1,33 Pa (0,01 torr) et la pression atmosphérique.

14. Procédé selon l'une quelconque des revendications 9 à 13, caractérisé en ce que le rapport entre le débit du gaz d'hydrure de silicium et le débit du gaz d'halogénure métallique est compris entre environ 0,2 et environ 5.

15. Procédé selon l'une quelconque des revendications 9 à 14, caractérisé en ce que le gaz d'hydrure de silicium est le silane, SiH₄, et le gaz d'halogénure métallique est un gaz d'halogénure de tungstène.

16. Procédé selon la revendication 15, caractérisé en ce que le rapport du débit du gaz de silane au débit du gaz d'halogénure de tungstène est compris entre environ 0,5 et environ 0,8.

17. Procédé selon la revendication 15, caractérisé en ce que le rapport du débit du gaz de silane au débit du gaz d'halogénure de tungstène est supérieur à 0,8.

18. Procédé selon l'une quelconque des revendications 9 à 14, caractérisé en ce que le gaz d'hydrure de silicium est le silane SiH₄ et le gaz d'halogénure métallique est un gaz d'halogénure de molybdène.

19. Procédé selon la revendication 18, caractérisé en ce que le rapport du débit du gaz de silane au débit du gaz d'halogénure de molybdène est compris entre environ 2 et 5.

20. Procédé selon l'une quelconque des revendications 15 à 19, caractérisé en ce que la température est comprise entre environ 300°C et environ 600°C.
